# EUROPEAN PATENT SPECIFICATION

(11) **EP 4 514 083 B1**
(45) Date of publication and mention of the grant of the patent: **25.11.2026**
(21) Application number: 23829372.4
(22) Date of filing: 28.01.2023
(51) Int. Cl.: H05K 7/20, F28F 3/04, F28F 3/12

(54) **HEAT CONDUCTION PLATE, HEAT DISSIPATION APPARATUS, AND ELECTRONIC DEVICE**
WÄRMELEITPLATTE, WÄRMEABLEITUNGSVORRICHTUNG UND ELEKTRONISCHE VORRICHTUNG
PLAQUE DE CONDUCTION DE CHALEUR, APPAREIL DE DISSIPATION DE CHALEUR ET DISPOSITIF ÉLECTRONIQUE

(30) Priority: 29.06.2022 CN 202210747500
(43) Date of publication of application: 26.02.2025
(73) Proprietor: ZTE Corporation, Shenzhen, Guangdong 518057 (CN)
(72) Inventor: DUAN, Kaiwen, Shenzhen, Guangdong 518057 (CN); NIE, Zhidong, Shenzhen, Guangdong 518057 (CN); LIU, Xin, Shenzhen, Guangdong 518057 (CN); WANG, Yan, Shenzhen, Guangdong 518057 (CN); LIU, Fan, Shenzhen, Guangdong 518057 (CN); LI, Shuai, Shenzhen, Guangdong 518057 (CN)
(74) Representative: Savi, Massimiliano
(86) International application number: PCT/CN2023/073625
(87) International publication number: WO 2024/001179

(56) References cited:
- WO-A1-2009/088135
- CN-A- 111 473 670
- CN-A- 111 521 051
- CN-A- 111 609 743
- CN-A- 111 741 649
- CN-A- 111 818 780
- CN-U- 212 458 057
- US-B2- 10 820 448

## Description

### TECHNICAL FIELD

Embodiments of the present disclosure relate to the technical field of heat dissipation, and more particularly, to a heat conducting plate, a heat dissipation apparatus, and an electronic device.

### BACKGROUND

As electronic devices evolve towards higher power, greater integration, and lighter weight, their heat generation density increases, leading to greater demands for efficient heat dissipation. In related heat dissipation technologies, a heat conducting plate using a two-phase heat dissipation method is adopted.

However, existing heat conducting plates using two-phase heat dissipation technologies have low two-phase circulation efficiency, and heat dissipation apparatuses and electronic devices using the existing heat conducting plates have an unsatisfactory heat dissipation effect.

Therefore, there is an urgent need for a heat conducting plate, a heat dissipation apparatus, and an electronic device to address the problems of low two-phase circulation efficiency of heat conducting plates and an unsatisfactory heat dissipation effect of heat dissipation apparatuses and electronic devices.

US10820448B2 relates to a heat sink which includes a base and a plurality of fins. A root of the fin is connected to the base. A heated area, a dropping pipe, and a spacing strip between the heated area and the dropping pipe are formed in the fin. A first passage and a second passage are formed between the heated area and the dropping pipe. A hydraulic diameter of a pipeline in the heated area is less than a critical dimension. A hydraulic diameter of a pipeline of the dropping pipe is greater than or equal to the critical dimension, and a pressure of liquid at an intersection of the second passage and the dropping pipe is greater than a pressure of liquid at an intersection of the second passage and the heated area.

CN111473670A relates to a thermal superconducting heat transfer plate and a radiator. The thermal superconducting heat transfer plate comprises a radiating base plate and thermal superconducting heat transfer plate, wherein the thermal superconducting heat transfer plates comprise heat conducting plates of composite plate type structures, and each heat conducting plate comprises a heating region located on one side edge of the heat conducting plate, a condensing and radiating region located on the surface of the heat conducting plate and a non-pipeline blank region; and the condensing and radiating regions are located above the non-pipeline blank regions, radiating pipelines are formed in the heat conducting plates in the condensing and radiating regions, and the radiating pipelines are filled with heat transfer working media.

CN111741649A relates to a heat superconducting heat dissipation plate and a preparation method thereof, a radiator and a 5G base station device. The heat superconducting heat dissipation plate comprises a first heat superconducting region, a second heat superconducting region and a first isolation blocking region, the first heat superconducting region comprises a first liquid phase evaporation region and a first gas phase condensation heat dissipation region, and the second heat superconducting region comprises a second liquid phase evaporation region and a second gas phase condensation heat dissipation region. The first isolation blocking area is positioned between the second liquid phase evaporation area and the first gas phase condensation heat dissipation area, is used for isolating the second liquid phase evaporation area from the first gas phase condensation heat dissipation area, and extends from the bottom of the second liquid phase evaporation area to one side, deviating from the heat source, of the second liquid phase evaporation area; the first heat dissipation pipeline and the second heat dissipation pipeline are both heat superconducting heat dissipation pipelines, and the heat superconducting heat dissipation pipelines are filled with heat transfer working media.

CN111818780A relates to a liquid-gas shunting type heat dissipation module. The module comprises a heat dissipation plate, wherein a condensation area is arranged on the heat dissipation plate, a heat dissipation pipeline is arranged in the condensation area, the heat dissipation pipe can be formed through a punch forming and brazing process or a hot rolling blowing process, a heat dissipation plate surface is provided with hollow pipeline spaces which are respectively set as condensation areas, refrigerants are arranged in the condensation area, the condensation area is provided with at least one steam channel and at least one liquid backflow channel, a heat dissipation pipe is arranged on a bottom surface of the heat dissipation plate in an attached mode, the heat dissipation pipe and a steam channel are communicated through a connecting assembly, the heat dissipation pipe and the liquid backflow channel are communicated through a connecting assembly, and complete circulation is formed.

CN111609743A , disclosing the features of the preamble of claim 1, relates to a thermal superconducting heat dissipation plate, a radiator and 5G base station equipment. The thermal superconducting heat dissipation plate comprises a first heat dissipation area and a second heat dissipation area located at the upper part of the first heat dissipation area; a first heat dissipation pipeline is distributed in the first heat dissipation area in a polygonal honeycomb; a second heat dissipation pipeline is distributed in the second heat dissipation area, and comprises a plurality of second main pipelines and a plurality of second branches connected between the second main pipelines; the second main pipelines extend along the width direction of the thermal superconducting heat dissipation plate; ends, far from a device, of the second main pipelines are inclined toward the direction away from the first heat dissipation area; the first heat dissipation pipeline communicates with the second heat dissipation pipeline, and the two are the thermal superconducting heat dissipation pipeline; the thermal superconducting heat dissipation pipeline is filled with a heat transfer working medium; and the heat transfer working medium in the first heat dissipation pipeline comprises a liquid.

### SUMMARY

The invention is set out in the appended set of claims.

Embodiments of the present disclosure provide a heat conducting plate, a heat dissipation apparatus, and an electronic device.

In accordance with a first aspect of the present disclosure, an embodiment provides a heat conducting plate, including: a heat conducting plate body, and a first heat dissipation zone, a second heat dissipation zone, and a third heat dissipation zone which are arranged on the heat conducting plate body. The first heat dissipation zone is arranged adjacent to a first side of the heat conducting plate body. The first side of the heat conducting plate body is configured as a heat input end. The second heat dissipation zone is arranged adjacent to the first heat dissipation zone, and the second heat dissipation zone is provided with a second heat dissipation channel. The third heat dissipation zone is arranged adjacent to the first heat dissipation zone and the second heat dissipation zone, and the third heat dissipation zone is provided with a third heat dissipation channel. The second heat dissipation channel includes at least a mesh-shaped channel. The third heat dissipation channel includes at least a strip-shaped channel. The second heat dissipation channel is communicated with the third heat dissipation channel.

In accordance with a second aspect of the present disclosure, an embodiment provides a heat dissipation apparatus, including a base and the heat conducting plate according to the first aspect. The base is connected to the heat conducting plate.

In accordance with a third aspect of the present disclosure, an embodiment provides an electronic device, including the heat conducting plate according to the first aspect, or including the heat dissipation apparatus according to the second aspect.

### BRIEF DESCRIPTION OF DRAWINGS

FIG. 1 is a schematic structural sectional diagram of a heat conducting plate according to an embodiment of the present disclosure;
FIG. 2 is a schematic structural sectional diagram of a heat conducting plate according to an embodiment of the present disclosure;
FIG. 3 is a schematic structural sectional diagram of a heat conducting plate according to an embodiment of the present disclosure;
FIG. 4 is a schematic structural sectional diagram of a heat conducting plate according to an embodiment of the present disclosure;
FIG. 5 is a schematic structural sectional diagram of a heat conducting plate according to an embodiment of the present disclosure;
FIG. 6 is a schematic structural sectional diagram of a heat conducting plate according to an embodiment of the present disclosure;
FIG. 7a is a schematic structural sectional diagram of a heat conducting plate according to an embodiment of the present disclosure;
FIG. 7b is a schematic structural sectional diagram of a heat conducting plate according to an embodiment of the present disclosure; and
FIG. 7c is a schematic structural sectional diagram of a heat conducting plate according to an embodiment of the present disclosure.

Reference numerals:
1: heat conducting plate;
10: first heat dissipation zone; 20: second heat dissipation zone; 30: third heat dissipation zone; 40: coupling zone; and 50: collecting groove;
101: first heat dissipation channel; 201: second heat dissipation channel; 202: first closed unit; 301: third heat dissipation channel; 302: second closed unit; and 401: coupling zone channel; and
2011: diffusion pipe; 3011: guide pipe; and 3012: communicating pipe.

### DETAILED DESCRIPTION

To make the objectives, technical schemes, and advantages of the present disclosure clearer and more comprehensible, the present disclosure is further described below in detail in conjunction with the accompanying drawings and embodiments. It should be understood that the specific embodiments described herein are merely used to illustrate the present disclosure and are not intended to limit the present disclosure.

In the descriptions of the embodiments of the present disclosure, the terms such as "first", "second" and the like (if any) used herein are merely used for distinguishing technical features, and are not intended to indicate or imply relative importance, or implicitly point out the number of the indicated technical features, or implicitly point out a precedence order of the indicated technical features.

It should be understood that, terms such as "upper", "lower", "front", "rear", "left", "right" and the like should be construed to refer to the orientation or positional relationships as then described or as shown in the drawings under discussion. These relative terms are for convenience of description and do not require that the apparatus or elements of the present disclosure have a particular orientation or be constructed or operated in a particular orientation. Unless otherwise explicitly limited, terms such as "arrange", "install", "connect" and the like should be understood in a broad sense. Those having ordinary skills in the art can properly determine specific meanings of the terms in the embodiments of the present disclosure based on specific contents of the technical schemes.

Reference throughout this description to "an embodiment", "some embodiments", "an example embodiment", "a specific example", or "some examples" means that a particular feature, structure, material, or characteristic described in connection with the embodiment or example is included in at least one embodiment or example of the present disclosure. Thus, the appearances of the phrases throughout this description are not necessarily referring to the same embodiment or example of the present disclosure. Furthermore, the particular features, structures, materials, or characteristics may be combined in any suitable manner in one or more embodiments or examples.

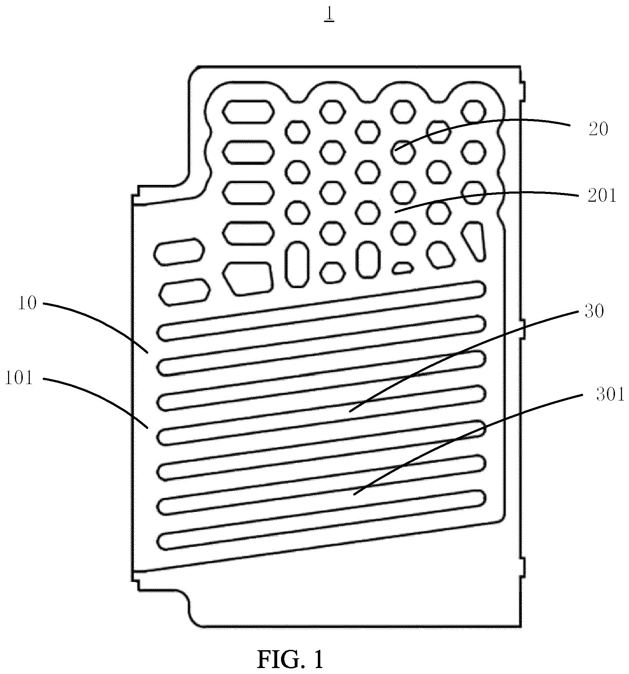

With reference to FIG. 1, an embodiment of the present disclosure provides a heat conducting plate 1, including: a heat conducting plate body, and a first heat dissipation zone 10, a second heat dissipation zone 20, and a third heat dissipation zone 30 which are arranged on the heat conducting plate body. The first heat dissipation zone 10 is arranged adjacent to a first side of the heat conducting plate body. The first side of the heat conducting plate body is configured as a heat input end. The second heat dissipation zone 20 is arranged adjacent to the first heat dissipation zone 10, and the second heat dissipation zone 20 is provided with a second heat dissipation channel 201. The third heat dissipation zone 30 is arranged adjacent to the first heat dissipation zone 10 and the second heat dissipation zone 20, and the third heat dissipation zone 30 is provided with a third heat dissipation channel 301. The second heat dissipation channel 201 is communicated with the third heat dissipation channel 301.

The heat conducting plate 1 further includes a heat-conducting working medium configured to flow in the second heat dissipation channel 201 and the third heat dissipation channel 301. The second heat dissipation channel 201 is configured to liquefy at least part of the heat-conducting working medium. The liquefied heat-conducting working medium in the second heat dissipation channel 201 flows to the third heat dissipation channel 301 through the second heat dissipation channel 201. The second heat dissipation channel 201has a different structure from the third heat dissipation channel 301.

In some implementations, the second heat dissipation channel 201 includes at least a mesh-shaped channel. The mesh-shaped channel is a non-directional array channel that helps diffuse a vapor-state heat-conducting working medium. The vapor-state heat-conducting working medium flows in a plurality of directions in the second heat dissipation channel 201 to achieve a higher flow efficiency and a larger contact area to accelerate condensation of the heat-conducting working medium. The flow directions of the vapor-state heat-conducting working medium in the second heat dissipation channel 201 are affected at least by a local temperature difference, an air density difference, an air pressure difference, a channel form, and the like inside the second heat dissipation channel 201. It can be understood that the second heat dissipation channel 201 may be a non-linear channel, i.e., an inlet and an outlet of the non-linear channel are not in one-to-one correspondence. For example, the second heat dissipation channel 201 may be in a shape similar to a grid or a honeycomb.

The third heat dissipation channel 301 includes at least a strip-shaped channel. The strip-shaped channel is a directional guide channel that helps guide a liquid-state heat-conducting working medium. The liquid-state heat-conducting working medium has a clear flow direction in the third heat dissipation channel 301 to achieve a directional flow of the heat-conducting working medium in the third heat dissipation channel 301 to improve return efficiency. The liquid-state heat-conducting working medium flows in a relatively specific direction in the third heat dissipation channel 301, i.e., at least flows along the interior of the third heat dissipation channel 301 under driving of self-gravity of the liquid-state heat-conducting working medium. It can be understood that the third heat dissipation channel 301 may be a linear channel. The linear channel has an inlet and outlet clearly in one-to-one correspondence.

Further, due to a density difference between the vapor-state heat-conducting working medium and the liquid-state heat-conducting working medium, as affected by a pressure difference and thermal buoyancy, the light-density vapor-state heat-conducting working medium tends to quickly gather at an upper part of the heat conducting plate 1. In this way, the heat-conducting working medium in the third heat dissipation channel 301 has fewer and independent flow paths, a unitary discharge path, and larger flow resistance, while the heat-conducting working medium in the second heat dissipation channel 201 has more and intersecting flow paths, so that diffusion paths of the vapor-state heat-conducting working medium can be significantly increased to reduce diffusion resistance. In addition, it is more difficult for the vapor-state heat-conducting working medium to climb upward in the third heat dissipation channel 301 than in the second heat dissipation channel 201, and the second heat dissipation channel 201 provides a large number of upward channels and lateral diffusion channels for the vapor-state heat-conducting working medium, which helps the vapor-state heat-conducting working medium to gather upwards and diffuse in a plane direction, thereby reducing upward resistance and diffusion resistance of vapor and improving diffusion efficiency. Further, it is easier for the second heat dissipation channel 201 to increase density than the third heat dissipation channel 301, so that a contact area between the second heat dissipation channel 201 and the heat-conducting working medium can be significantly increased, and the vapor-state heat-conducting working medium can obtain a greater condensation area for exothermic condensation, thereby improving condensation efficiency.

It can be understood that the heat-conducting working medium enters the second heat dissipation channel 201 mainly in a vapor form, and enters the third heat dissipation channel 301 mainly in a liquid form. Under a joint action of diffusion and condensation functions of the second heat dissipation channel 201 and guide and return functions of the third heat dissipation channel 301, a heat conduction cycle of the heat-conducting working medium is realized, thereby improving two-phase circulation efficiency of the heat-conducting working medium.

In some implementations, the first heat dissipation zone 10 is provided with a first heat dissipation channel 101. The first heat dissipation channel 101 is communicated with the third heat dissipation channel 301, to receive the heat-conducting working medium from the third heat dissipation channel 301. The first heat dissipation channel 101 is arranged to provide a space for the heat-conducting working medium to transform from the liquid state to the vapor state. Therefore, a phase change occurring in the first heat dissipation channel 101 mainly includes the transformation from the liquid state to the vapor state, and because this process involves mainly heat absorption, the first heat dissipation zone 10 is arranged close to the heat input end of the heat conducting plate 1, and the first heat dissipation channel 101 is arranged on a side of the third heat dissipation channel 301 close to the heat input end. It can be understood that, to enable the vapor-state heat-conducting working medium to enter the second heat dissipation channel 201 to achieve a satisfactory circulation effect, the first heat dissipation channel 101 is further communicated with the second heat dissipation channel 201. The first heat dissipation channel 101 is configured to vaporize the heat-conducting working medium. The vaporized heat-conducting working medium flows to the second heat dissipation channel 201 through the first heat dissipation channel 101. Therefore, a communication status in this case is that the second heat dissipation channel 201 is communicated with the third heat dissipation channel 301, the third heat dissipation channel 301 is communicated with the first heat dissipation channel 101, and the first heat dissipation channel 101 is communicated with the second heat dissipation channel 201. A phase change of the heat-conducting working medium in the second heat dissipation channel 201 is liquefaction, the heat-conducting working medium in the third heat dissipation channel 301 is mainly a liquefied heat-conducting working medium, and is guided into the first heat dissipation channel 101, and the liquefied heat-conducting working medium in the first heat dissipation channel 101 is mainly vaporized.

It can be understood that the first heat dissipation channel 101 may be a hollow pipe structure, which can provide a space for the vapor-state heat-conducting working medium to flow freely. Alternatively, the first heat dissipation channel 101 may be a mesh pipe structure that is not completely hollow inside. The mesh pipe structure provides a larger contact area between the liquid-state heat-conducting working medium and the first heat dissipation channel 101, which helps accelerate evaporation of the liquid-state heat-conducting working medium.

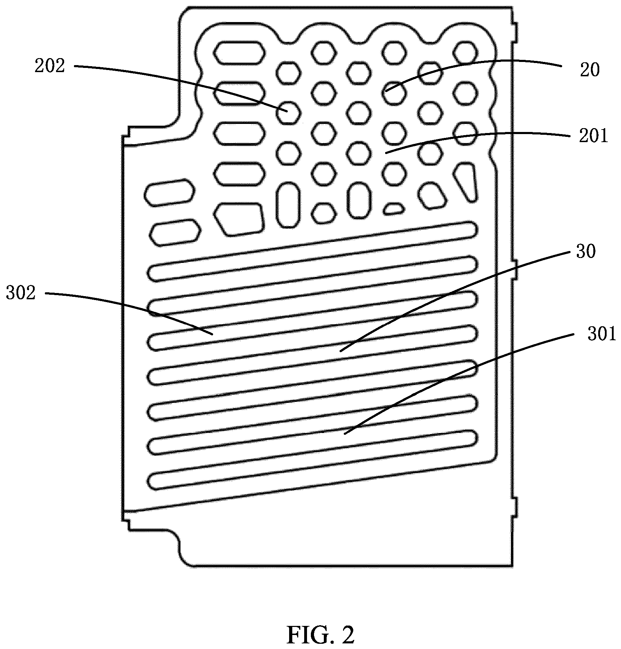

With reference to FIG. 2, the second heat dissipation zone 20 includes a plurality of first closed units 202. In some implementations, the plurality of first closed units 202 form the second heat dissipation zone 20 together with the second heat dissipation channel 201 through at least one of offset, arraying, or outward expansion. Shapes of the first closed units 202 include, but not limited to, one or a combination of at least two of a circle, an ellipse, a triangle, a quadrilateral, a pentagon, a hexagon, or other polygons. The first closed units 202 of a single shape and size or a plurality of shapes and sizes are arranged to form a regular or irregular structure. It can be understood that the first closed units 202 include at least one shape or size. The second heat dissipation channel 201 is arranged at least partly around the first closed units 202, and the first closed units 202 are arranged at multi points. This can increase the flow paths and a condensation area of the vapor-state heat-conducting working medium in the second heat dissipation channel 201, and reduce diffusion resistance of the vapor-state heat-conducting working medium.

The third heat dissipation zone 30 includes a plurality of second closed units 302. In some implementations, the plurality of second closed units 302 form the third heat dissipation zone 30 together with the third heat dissipation channel 301 through at least one of offset, arraying, and outward expansion. Shapes of the second closed unit 302 include, but not limited to, one or a combination of at least two of a quadrilateral, an oval, or other polygons. In some implementations, the second closed units 302 are oval. The second closed units 302 of a single shape and size or a plurality of shapes and sizes are arranged to form a regular or irregular structure. The second closed units 302 include at least one shape or size. The third heat dissipation channel 301 is arranged at least partly around the second closed units 302.

In some implementations, the first closed unit 202 and the second closed unit 302 have different shapes, or the first closed unit 202 and the second closed unit 302 have different sizes, which includes at least a case that the first closed unit 202 and the second closed unit 302 have different shapes and sizes, and a case that the first closed unit 202 and the second closed unit 302 have the same shape but different sizes.

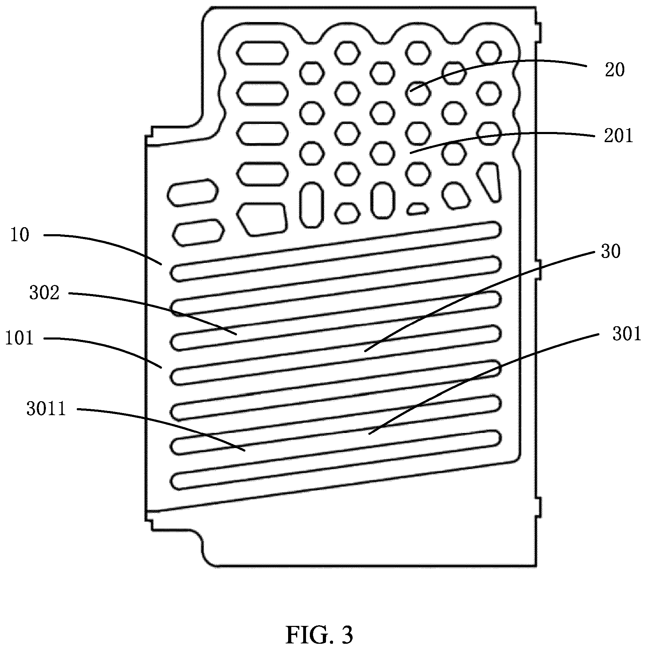

With reference to FIG. 3, the third heat dissipation channel 301 includes a plurality of guide pipes 3011 which are spaced apart. In some implementations, the second closed unit 302 is arranged between adjacent guide pipes 3011 to achieve spacing of the guide pipes 3011.

In some implementations, the guide pipe 3011 has an inlet arranged close to the second heat dissipation zone 20 and an outlet arranged close to the first heat dissipation zone 10, such that the liquid-state heat-conducting working medium flows by self-gravity in a direction from the inlet to the outlet close to the heat input end. It can be understood that when the heat conducting plate 1 is in a working state, the outlet is at a lower position in a direction of gravity relative to the inlet, to help the liquid-state heat-conducting working medium to flow. In some implementations, an end of the guide pipe 3011 close to the second heat dissipation zone 20 has a greater diameter than an end of the guide pipe 3011 close to the first heat dissipation zone 10. In other words, the inlet has a greater diameter than the outlet, which increases flow resistance of the vapor-state heat-conducting working medium in the guide pipe 3011, such that the vapor-state heat-conducting working medium in the first heat dissipation channel 101 tends to diffuse from an upper part to the second heat dissipation channel 201 instead of entering the third heat dissipation channel 301 from a lower part of the first heat dissipation channel 101 through the small-diameter guide pipe 3011, thereby facilitating two-phase directional circulation. In some implementations, a diameter of the guide pipe 3011 from the inlet to the outlet is set to gradually decreasing, to facilitate drainage of the liquid-state heat-conducting working medium inside, and increase flow resistance of the vapor-state heat-conducting working medium.

In some implementations, at an end of the third heat dissipation channel 301 close to the heat input end, the guide pipes 3011 are arranged spaced apart along a dripping direction under gravity of the liquid-state heat-conducting working medium for liquid replenishment to different parts of a heat source in the direction of gravity, to improve balance of heat absorption from the heat source. In some implementations, the liquid-state heat-conducting working medium can fully flush and soak the end of the near-heat source third heat dissipation channel 301 close to the heat input end or the first heat dissipation channel 101 from top to bottom along the direction of gravity, which helps resolve a problem of dry burning of an upper part of the third heat dissipation channel 301 near the heat source or an upper part of the first heat dissipation channel 101 due to lack of liquid.

In some implementations, an angle between the end of the guide pipe 3011 close to the first heat dissipation zone 10 and a first direction is less than 45 degrees. In an implementation, the first direction refers to a direction perpendicular to a length of the first heat dissipation channel 101 in a plane where the guide pipe 3011 is located, and is usually a horizontal direction perpendicular to the direction of gravity in a use state. Such an arrangement helps lead out more guide pipes 3011 within a limited area, thereby increasing pipe density and distributing the heat-conducting working medium more evenly.

In some implementations, the plurality of guide pipes 3011 have the same length. With the same length, flow time of the liquid-state heat-conducting working medium in different guide pipes 3011 tends to be the same, such that liquid replenishment efficiency of different guide pipes 3011 is similar.

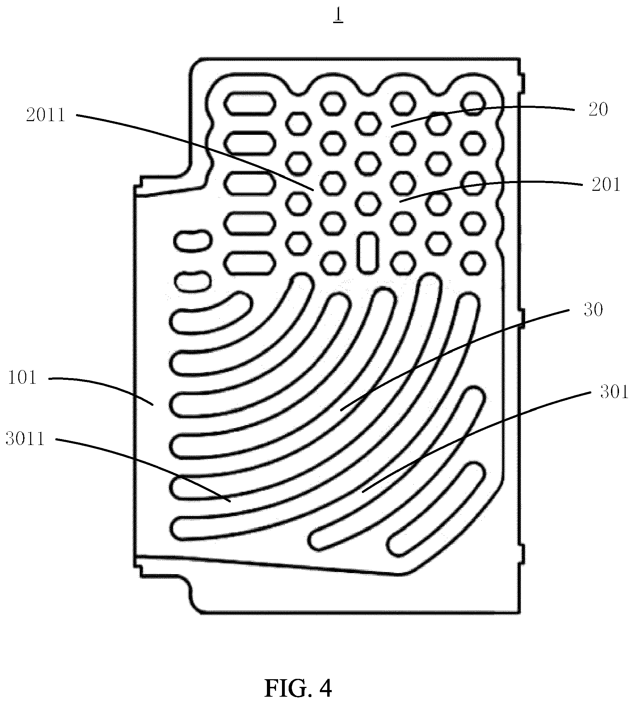

In other implementations, with reference to FIG. 4, at least two guide pipes 3011 have different lengths. The guide pipes 3011 of different lengths shorten flow paths of the liquid-state heat-conducting working medium and reduce flow time, such that the liquid-state heat-conducting working medium reaches the heat input end faster. Because the heat input end usually extends a certain distance in a certain direction, heat distribution is uneven or different parts need to dissipate different amounts of heat. Therefore, guide pipes 3011 of different lengths may be arranged for different parts of the third heat dissipation channel 301 close to the heat input end, to achieve different liquid replenishment efficiency and improve heat dissipation efficiency.

In an implementation, lengths of at least some of adjacent guide pipes 3011 increase gradually. It can be understood that, in two adjacent guide pipes 3011, there is a short guide pipe 3011 and a long guide pipe 3011, and another guide pipe 3011 adjacent to the long guide pipe 3011 is a longer guide pipe 3011. Therefore, lengths of the guide pipes 3011 arranged in this implementation increase gradually, where part of the third heat dissipation channel 301 is in a radially outward expansion structure. In this implementation of the third heat dissipation channel 301, the guide pipes 3011 are led out from the first heat dissipation channel 101, extend to a lower end of the second heat dissipation channel 201, and form direct communication. Further, the liquid-state heat-conducting working medium formed in the second heat dissipation zone 20 may be directly distributed to the guide pipes 3011 by the second heat dissipation channel 201, and finally is directionally guided to different height directions of the first heat dissipation channel 101 for liquid replenishment. It can be understood that the liquid-state working medium distributed from the second heat dissipation zone 20 to the channels in the third heat dissipation zone 30 is more even, and has a higher directional circulation fluidity.

It can be understood that the second heat dissipation channel 201 includes a diffusion pipe 2011. The diffusion pipe 2011 is arranged around the first closed units, and the vapor-state heat-conducting working medium flows and diffuses in the diffusion pipe 2011.

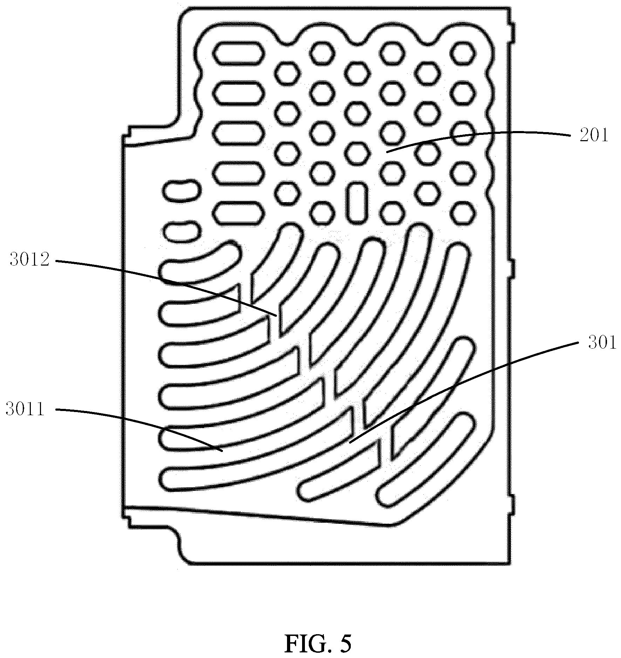

With reference to FIG. 5, in some implementations, the third heat dissipation zone 30 is provided with a communicating pipe 3012. The communicating pipe 3012 connects adjacent guide pipes 3011. The guide pipes 3011 are first connected through the communicating pipe 3012 and then communicated with the second heat dissipation channel 201. The communicating pipe 3012 is arranged penetrating the third heat dissipation channel 301. The communicating pipe 3012 connects two adjacent guide pipes 3011, such that the liquid-state heat-conducting working medium can flow from one guide pipe 3011 to another guide pipe 3011 through the communicating pipe 3012. Therefore, the communicating pipe 3012 can adjust the flow rate of the liquid-state heat-conducting working medium in different guide pipes 3011, to effectively dissipate heat for different heat source conditions.

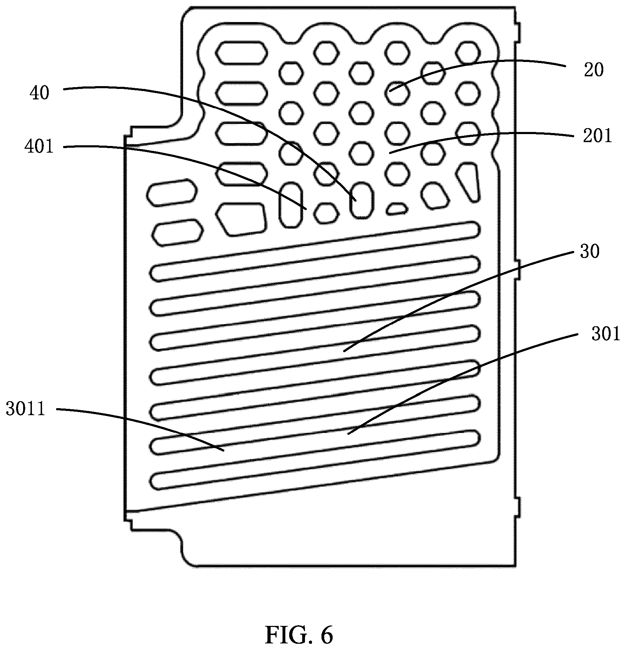

With reference to FIG. 6, in some implementations, a coupling zone 40 is arranged between the second heat dissipation zone 20 and the third heat dissipation zone 30. The second heat dissipation channel 201 is communicated with the third heat dissipation channel 301 by means of the coupling zone 40. A coupling zone channel 401 is a transitional channel form between the second heat dissipation channel 201 and the third heat dissipation channel 301, which can completely separate the second heat dissipation channel 201 from the third heat dissipation channel 301, or partly separate the second heat dissipation channel 201 from the third heat dissipation channel 301.

In some implementations, a boundary of the coupling zone channel 401 defines mainly a linear strip-shaped channel, which is adapted to be locally coupled to a contact part of the second heat dissipation channel 201, to implement transitional communication. In addition, a satisfactory guide effect of the linear strip-shaped channel can be well matched with the third heat dissipation channel 301 to maintain a linear guide effect of the third heat dissipation channel 301 to a greater extent, thereby improving directional liquid return efficiency.

In some implementations, the coupling zone channel 401 is mainly configured for flow distribution rather than guiding. In this case, the coupling zone channel 401 is mainly in a mesh-shaped channel form instead of a linear strip-shaped channel with a clear path. After the vapor-state heat-conducting working medium is liquefied in the second heat dissipation channel 201, a mesh-shaped channel is specifically arranged according to different flow rates after liquefaction in different parts, such that the liquid-state heat-conducting working medium can be evenly distributed when flowing through the coupling zone 40 and flow into the guide pipes 3011 in the third heat dissipation channel 301, to improve liquid replenishment efficiency of the third heat dissipation channel 301.

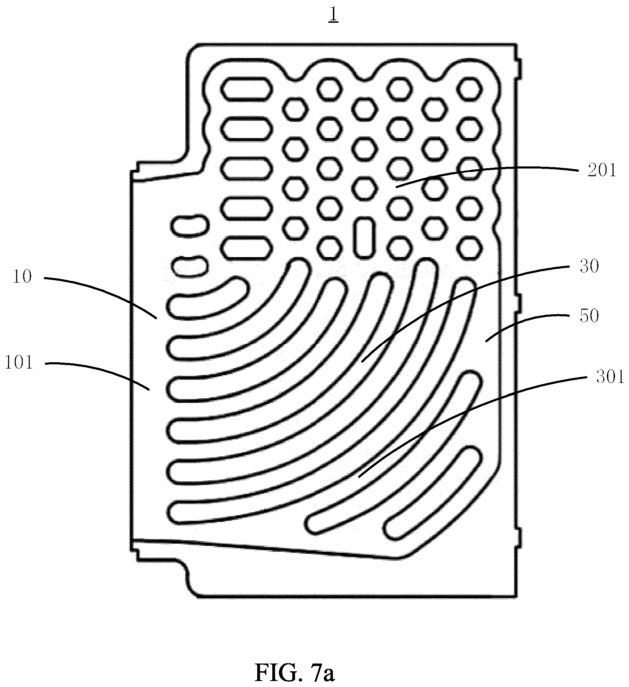

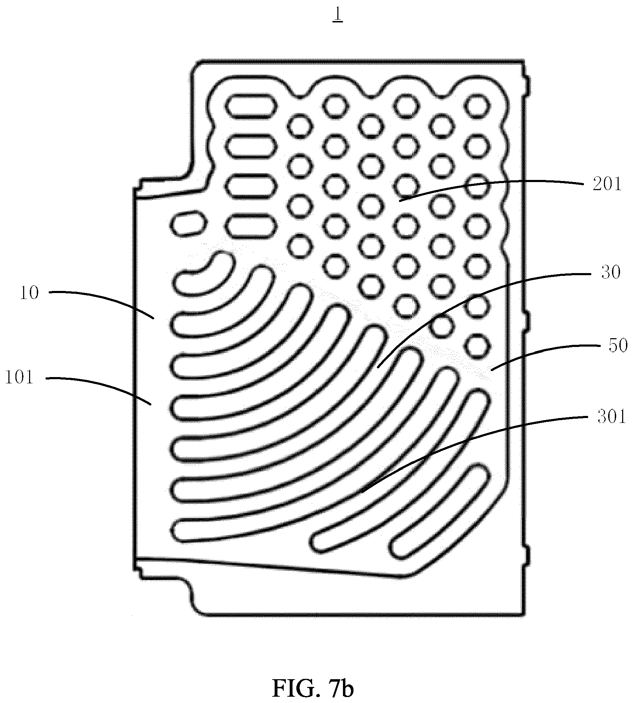

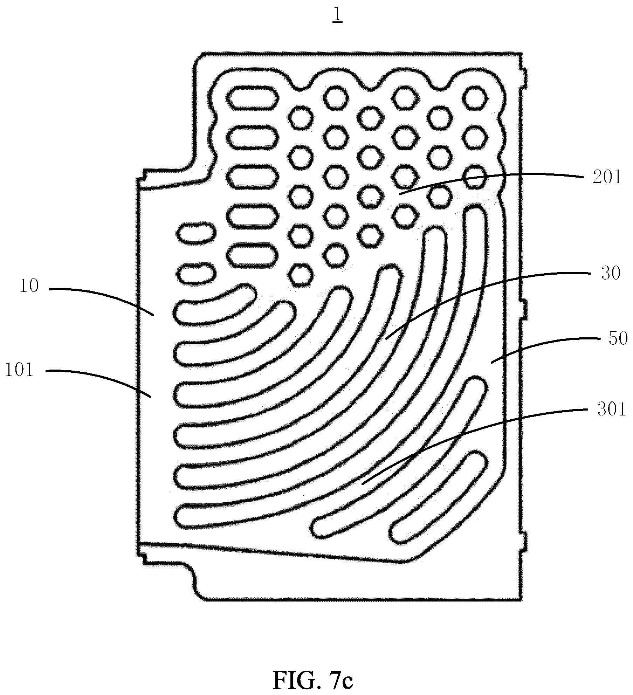

With reference to FIG. 7a, FIG. 7b, and FIG. 7c together, a part where the second heat dissipation channel 201 is adjacent to the third heat dissipation channel 301 may be provided with different structures according to different heat source conditions, including at least one of the following three manners: shifting in a direction from a position of the third heat dissipation channel 301 towards the first heat dissipation channel 101, shifting in a direction from a position of the second heat dissipation channel 201 towards the first heat dissipation channel 101, and not shifting. When the adjacent part is set to shifting in the direction from the position of the third heat dissipation channel 301 towards the first heat dissipation channel 101, the second heat dissipation channel 201 has a larger condensation area than in a not shifting case, thereby improving condensation efficiency. When the adjacent part is set to shifting in the direction from the position of the second heat dissipation channel 201 towards the first heat dissipation channel 101, the liquid-state heat-conducting working medium can enter the third heat dissipation channel 301 and return earlier when condensation efficiency is met.

In an implementation, the heat conducting plate 1 is provided with a collecting groove 50 on a side of the third heat dissipation channel 301 near the first heat dissipation zone 10. The collecting groove 50 is communicated with both the second heat dissipation channel 201 and the third heat dissipation channel 301. It can be understood that the vapor-state heat-conducting working medium flows from the first heat dissipation channel 101 to the second heat dissipation channel 201 mainly through the collecting groove 50.

In an implementation, a small amount of the vapor-state heat-conducting working medium in the first heat dissipation channel 101 may enter the third heat dissipation channel 301, or part of the liquid-state working medium inside the third heat dissipation channel 301 may vaporize. In this case, the vapor-state heat-conducting working medium in the third heat dissipation channel 301 may flow through the third heat dissipation channel 301 to the collecting groove 50 on the side of the third heat dissipation zone 30 away from the first heat dissipation zone 10 to be collected, and then flow to the second heat dissipation channel 201 communicated with the collecting groove 50. In addition, the collecting groove 50 herein further functions to help the second heat dissipation channel 201 to transport the liquid-state heat-conducting working medium to the third heat dissipation channel 301.

An embodiment of the present disclosure provides a heat dissipation apparatus. The heat dissipation apparatus selectively uses the structure of the heat conducting plate 1, and the heat dissipation apparatus includes, but not limited to, heat dissipation apparatuses used in electronic devices such as an Active Antenna Unit (AAU), a Radio Remote Unit (RRU), a charging pile device, and a lighting device. In an implementation, the heat dissipation apparatus includes a base connected to the heat conducting plate 1. When an inner cavity of the base is communicated with the heat conducting plate 1, the heat conducting plate 1 is provided with an open nozzle, that is, the heat input end of the heat conducting plate 1 is provided with an open nozzle, and the inner cavity of the base is communicated with the heat conducting plate 1 through the open nozzle. Therefore, the inner cavity of the base may be communicated with the first heat dissipation channel 101 of the heat conducting plate 1 through the open nozzle, and a heat-conducting working medium can flow into and out of the inner cavity of the base through the open nozzle, to significantly improve overall two-phase temperature equalization and heat dissipation efficiency of the heat dissipation apparatus. In another implementation, the inner cavity of the base is not communicated with the heat conducting plate 1, and the heat conducting plate 1 has a closed nozzle, that is, the heat input end of the heat conducting plate 1 has a closed nozzle, and the heat-conducting working medium flows only inside the heat conducting plate 1. This simplifies the connection between the heat conducting plate 1 and the base, and reduces a process/production failure rate and leakage rate.

In some implementations, with the adoption of the heat conducting plate 1, the heat dissipation apparatus has beneficial effects of corresponding structures of the heat conducting plate 1, including at least as follows: A vapor-state heat-conducting working medium flows in a plurality of directions in the second heat dissipation channel 201 to achieve a higher flow efficiency and a larger contact area to accelerate condensation of the heat-conducting working medium. A liquid-state heat-conducting working medium has a clear flow direction in the third heat dissipation channel 301 for directional flow of the heat-conducting working medium in the third heat dissipation channel 301 to improve return efficiency. Under a joint action of a diffusion function of the second heat dissipation channel 201 and a guide function of the third heat dissipation channel 301, a heat conduction cycle of the heat-conducting working medium is realized, thereby improving two-phase circulation efficiency of the heat-conducting working medium.

An embodiment of the present disclosure provides an electronic device. The electronic device selectively uses the structure of the heat conducting plate 1, or selectively uses the structure of the heat dissipation apparatus. The electronic device includes, but not limited to, base station devices such as an AAU or an RRU, electromechanical devices such as a charging pile device or a lighting device, or other communication electronic devices such as a mobile phone or a computer. The electronic device dissipates heat by utilizing the heat conducting plate 1 or the heat dissipation apparatus to reduce an operating temperature. Further, when using the structure of the heat conducting plate 1 or the heat dissipation apparatus, the electronic device has beneficial effects of corresponding structures of the heat conducting plate 1, including at least as follows: A vapor-state heat-conducting working medium flows in a plurality of directions in the second heat dissipation channel 201 to achieve a higher flow efficiency and a larger contact area to accelerate condensation of the heat-conducting working medium. A liquid-state heat-conducting working medium has a clear flow direction in the third heat dissipation channel 301 for directional flow of the heat-conducting working medium in the third heat dissipation channel 301 to improve return efficiency. Under a joint action of a diffusion function of the second heat dissipation channel 201 and a guide function of the third heat dissipation channel 301, a heat conduction cycle of the heat-conducting working medium is realized, thereby improving two-phase circulation efficiency of the heat-conducting working medium.

In the heat conducting plate according to the embodiments of the present disclosure, a first heat dissipation zone, a second heat dissipation zone, and a third heat dissipation zone are arranged on a heat conducting plate body, and different heat dissipation zones are mainly responsible for different phase changes or specific functions, such that the phase changes occur cyclically and orderly. In addition, the arrangement of different zones makes a heat conduction path in the heat conducting plate clear and improves heat conduction efficiency. The second heat dissipation zone is provided with a second heat dissipation channel, the third heat dissipation zone is provided with a third heat dissipation channel, the second heat dissipation channel includes at least a mesh-shaped channel, the third heat dissipation channel includes at least a strip-shaped channel, and the second heat dissipation channel is communicated with the third heat dissipation channel. The mesh-shaped channel is a non-directional array channel that helps diffuse a vapor-state heat-conducting working medium. The vapor-state heat-conducting working medium flows in a plurality of directions in the second heat dissipation channel to achieve a higher flow efficiency and a larger contact area to accelerate condensation of the heat-conducting working medium. The strip-shaped channel is a directional guide channel that helps guide flow of a liquid-state heat-conducting working medium. The liquid-state heat-conducting working medium has a clear flow direction in the third heat dissipation channel for directional flow of the heat-conducting working medium in the third heat dissipation channel to improve return efficiency. Under a joint action of a diffusion function of the second heat dissipation channel and a guide function of the third heat dissipation channel, a heat conduction cycle of the heat-conducting working medium is realized, thereby improving two-phase circulation efficiency of the heat-conducting working medium.

## Claims

1. A heat conducting plate (1), comprising: a heat conducting plate body, a heat-conducting working medium and a first heat dissipation zone (10), a second heat dissipation zone (20), and a third heat dissipation zone (30) which are arranged on the heat conducting plate body, wherein:
the first heat dissipation zone (10) is arranged adj acent to a first side of the heat conducting plate body, the first heat dissipation zone (10) comprises a first heat dissipation channel (101), and the first side of the heat conducting plate body is configured as a heat input end;
the second heat dissipation zone (20) is arranged adjacent to the first heat dissipation zone (10), and the second heat dissipation zone (20) is provided with a second heat dissipation channel (201);
the third heat dissipation zone (30) is arranged adjacent to the first heat dissipation zone (10) and the second heat dissipation zone (20), and the third heat dissipation zone (30) is provided with a third heat dissipation channel (301);
the second heat dissipation channel (201) comprises at least a mesh-shaped channel;
the third heat dissipation channel (301) comprises at least a strip-shaped channel; and
**characterized in that**,
the strip-shaped channel comprises a plurality of guide pipes (3011), and the plurality of guide pipes (3011) are spaced apart, wherein at least some of the guide pipes (3011) have one end communicated with the first heat dissipation zone (10) and the other end communicated with the second heat dissipation zone (20), lengths of some of adjacent guide pipes (3011) increase gradually, the heat-conducting working medium is configured to flow in the second heat dissipation channel (201) and the third heat dissipation channel (301), at least part of the heat-conducting working medium is configured to be liquefied in part of the second heat dissipation channel (201), and the liquefied heat-conducting working medium formed in the second heat dissipation zone (20) is directly distributed to the guide pipes (3011) by the second heat dissipation channel (201), and finally is directionally guided to different height directions of the first heat dissipation channel (101) for liquid replenishment.

2. The heat conducting plate (1) of claim 1, wherein at least part of the heat-conducting working medium is configured to be vaporized in part of the first heat dissipation channel (101), and at least part of the vaporized heat-conducting working medium flows to the second heat dissipation channel (201) through the first heat dissipation channel (101).

3. The heat conducting plate (1) of claim 1, wherein the second heat dissipation zone (20) comprises a plurality of first closed units (202), the third heat dissipation zone (30) comprises a plurality of second closed units (302), the first closed units (202) are surrounded by at least part of the second heat dissipation channel (201), the second closed units (302) are surrounded by at least part of the third heat dissipation channel (301), and the first closed units (202) and the second closed units (302) are configured as at least one of the following that:
the first closed units (202) are first closed units (202) comprising at least one shape or size;
the second closed units (302) are second closed units (302) comprising at least one shape or size;
at least some of the first closed units (202) have a different shape from the second closed units (302); or
at least some of the first closed units (202) have a different size from the second closed units (302).

4. The heat conducting plate (1) of claim 1, wherein the guide pipes (3011) are further configured as at least one of the following that:
an end of the guide pipe (3011) close to the second heat dissipation zone (20) has a greater diameter than an end of the guide pipe (3011) close to the first heat dissipation zone (10); and
an angle between the end close to the first heat dissipation zone (10) and a first direction is less than 45 degrees.

5. The heat conducting plate (1) of claim 1, wherein the third heat dissipation zone (30) comprises a communicating pipe (3012) which connects at least two adjacent guide pipes (3011).

6. The heat conducting plate (1) of any one of claims 1 to 5, wherein a coupling zone (40) is arranged between the second heat dissipation zone (20) and the third heat dissipation zone (30), and the second heat dissipation channel (201) and the third heat dissipation channel (301) are communicated by means of the coupling zone (40).

7. A heat dissipation apparatus, comprising the heat conducting plate (1) of any one of claims 1 to 6.

8. The heat dissipation apparatus of claim 7, wherein the heat dissipation apparatus comprises a base configured as at least one of the following that:
an inner cavity of the base is communicated with the heat conducting plate (1), the heat conducting plate (1) is provided with an open nozzle, and the inner cavity of the base is communicated with the heat conducting plate (1) through the open nozzle; or
the inner cavity of the base is not communicated with the heat conducting plate (1), and the heat conducting plate (1) has a closed nozzle.

9. An electronic device, comprising the heat conducting plate (1) of any one of claims 1 to 6.

10. An electronic device, comprising the heat dissipation apparatus of claim 7 or 8.

## Patentansprüche

1. Wärmeleitplatte (1), umfassend: einen Wärmeleitplattenkörper, ein wärmeleitendes Arbeitsmedium und eine erste Wärmeableitungszone (10), eine zweite Wärmeableitungszone (20) und eine dritte Wärmeableitungszone (30), die auf dem Wärmeleitplattenkörper angeordnet sind, wobei:
die erste Wärmeableitungszone (10) benachbart zu einer ersten Seite des Wärmeleitplattenkörpers angeordnet ist, wobei die erste Wärmeableitungszone (10) einen ersten Wärmeableitungskanal (101) umfasst und die erste Seite des Wärmeleitplattenkörpers als Wärmeeingangsende konfiguriert ist;
die zweite Wärmeableitungszone (20) benachbart zu der ersten Wärmeableitungszone (10) angeordnet ist und die zweite Wärmeableitungszone (20) mit einem zweiten Wärmeableitungskanal (201) versehen ist;
die dritte Wärmeableitungszone (30) benachbart zu der ersten Wärmeableitungszone (10) und der zweiten Wärmeableitungszone (20) angeordnet ist und die dritte Wärmeableitungszone (30) mit einem dritten Wärmeableitungskanal (301) versehen ist;
der zweite Wärmeableitungskanal (201) mindestens einen maschenförmigen Kanal umfasst;
der dritte Wärmeableitungskanal (301) mindestens einen streifenförmigen Kanal umfasst; und
**dadurch gekennzeichnet, dass**
der streifenförmige Kanal eine Vielzahl von Führungsrohren (3011) umfasst und die Vielzahl von Führungsrohren (3011) voneinander beabstandet sind, wobei mindestens einige der Führungsrohre (3011) ein Ende aufweisen, das mit der ersten Wärmeableitungszone (10) kommuniziert, und das andere Ende, das mit der zweiten Wärmeableitungszone (20) kommuniziert, wobei Längen von einigen benachbarten Führungsrohren (3011) allmählich zunehmen, das wärmeleitende Arbeitsmedium so konfiguriert ist, dass es im zweiten Wärmeableitungskanal (201) und im dritten Wärmeableitungskanal (301) strömt, wobei zumindest ein Teil des wärmeleitenden Arbeitsmediums so konfiguriert ist, dass es in einem Teil des zweiten Wärmeableitungskanals (201) verflüssigt wird, und das in der zweiten Wärmeableitungszone (20) gebildete verflüssigte wärmeleitende Arbeitsmedium durch den zweiten Wärmeableitungskanal (201) direkt an die Führungsrohre (3011) verteilt wird und schließlich zur Flüssigkeitsnachfüllung gerichtet in verschiedene Höhenrichtungen des ersten Wärmeableitungskanals (101) geleitet wird.

2. Wärmeleitplatte (1) nach Anspruch 1, wobei zumindest ein Teil des wärmeleitenden Arbeitsmediums so konfiguriert ist, dass es in einem Teil des ersten Wärmeableitungskanals (101) verdampft wird, und zumindest ein Teil des verdampften wärmeleitenden Arbeitsmediums durch den ersten Wärmeableitungskanal (101) zu dem zweiten Wärmeableitungskanal (201) strömt.

3. Wärmeleitplatte (1) nach Anspruch 1, wobei die zweite Wärmeableitungszone (20) eine Vielzahl von ersten geschlossenen Einheiten (202) umfasst, die dritte Wärmeableitungszone (30) eine Vielzahl von zweiten geschlossenen Einheiten (302) umfasst, die ersten geschlossenen Einheiten (202) von zumindest einem Teil des zweiten Wärmeableitungskanals (201) umgeben sind, die zweiten geschlossenen Einheiten (302) von zumindest einem Teil des dritten Wärmeableitungskanals (301) umgeben sind, und die ersten geschlossenen Einheiten (202) und die zweiten geschlossenen Einheiten (302) als mindestens eines von Folgendem konfiguriert sind, so dass:
die ersten geschlossenen Einheiten (202) erste geschlossene Einheiten (202) sind, die mindestens eine Form oder Größe umfassen;
die zweiten geschlossenen Einheiten (302) zweite geschlossene Einheiten (302) sind, die mindestens eine Form oder Größe umfassen;
zumindest einige der ersten geschlossenen Einheiten (202) eine andere Form als die zweiten geschlossenen Einheiten (302) aufweisen; oder
zumindest einige der ersten geschlossenen Einheiten (202) eine andere Größe als die zweiten geschlossenen Einheiten (302) aufweisen.

4. Wärmeleitplatte (1) nach Anspruch 1, wobei die Führungsrohre (3011) ferner als mindestens eines von Folgendem konfiguriert sind, so dass:
ein Ende des Führungsrohrs (3011) nahe der zweiten Wärmeableitungszone (20) einen größeren Durchmesser als ein Ende des Führungsrohrs (3011) nahe der ersten Wärmeableitungszone (10) aufweist; und
ein Winkel zwischen dem Ende nahe der ersten Wärmeableitungszone (10) und einer ersten Richtung weniger als 45 Grad beträgt.

5. Wärmeleitplatte (1) nach Anspruch 1, wobei die dritte Wärmeableitungszone (30) ein Verbindungsrohr (3012) umfasst, das mindestens zwei benachbarte Führungsrohre (3011) verbindet.

6. Wärmeleitplatte (1) nach einem der Ansprüche 1 bis 5, wobei eine Kopplungszone (40) zwischen der zweiten Wärmeableitungszone (20) und der dritten Wärmeableitungszone (30) angeordnet ist und der zweite Wärmeableitungskanal (201) und der dritte Wärmeableitungskanal (301) mittels der Kopplungszone (40) kommunizieren.

7. Wärmeableitungsvorrichtung, umfassend die Wärmeleitplatte (1) nach einem der Ansprüche 1 bis 6.

8. Wärmeableitungsvorrichtung nach Anspruch 7, wobei die Wärmeableitungsvorrichtung eine Basis umfasst, die als mindestens eines von Folgendem konfiguriert ist, so dass:
ein innerer Hohlraum der Basis mit der Wärmeleitplatte (1) kommuniziert, wobei die Wärmeleitplatte (1) mit einer offenen Düse versehen ist und der innere Hohlraum der Basis mit der Wärmeleitplatte (1) durch die offene Düse kommuniziert; oder
der innere Hohlraum der Basis nicht mit der Wärmeleitplatte (1) kommuniziert und die Wärmeleitplatte (1) eine geschlossene Düse aufweist.

9. Elektronische Vorrichtung, umfassend die Wärmeleitplatte (1) nach einem der Ansprüche 1 bis 6.

10. Elektronische Vorrichtung, umfassend die Wärmeableitungsvorrichtung nach Anspruch 7 oder 8.

## Revendications

1. Plaque conductrice de chaleur (1) comprenant : un corps de plaque conductrice de chaleur, un milieu de travail caloporteur et une première zone de dissipation thermique (10), une deuxième zone de dissipation thermique (20) et une troisième zone de dissipation thermique (30), qui sont disposées sur le corps de plaque conductrice de chaleur, dans laquelle :
la première zone de dissipation thermique (10) est adjacente à un premier côté du corps de plaque conductrice de chaleur, la première zone de dissipation thermique (10) comprend un premier canal de dissipation thermique (101), et le premier côté du corps de plaque conductrice de chaleur est configuré comme une extrémité d'entrée de chaleur ;
la deuxième zone de dissipation thermique (20) est adjacente à la première zone de dissipation thermique (10), et la deuxième zone de dissipation thermique (20) est pourvue d'un deuxième canal de dissipation thermique (201) ;
la troisième zone de dissipation thermique (30) est adjacente à la première zone de dissipation thermique (10) et de la deuxième zone de dissipation thermique (20), et la troisième zone de dissipation thermique (30) est pourvue d'un troisième canal de dissipation thermique (301) ;
le deuxième canal de dissipation thermique (201) comprend au moins un canal en forme de de réseau maillé ;
le troisième canal de dissipation thermique (301) comprend au moins un canal en forme de bande ; et
**caractérisée en ce que**:
le canal en forme de bande comprend une pluralité de tubes de guidage (3011), et les tubes de guidage (3011) sont espacés les uns des autres, dans laquelle au moins certains des tubes de guidage (3011) ont une extrémité en communication avec la première zone de dissipation thermique (10) et l'autre extrémité en communication avec la deuxième zone de dissipation thermique (20), les longueurs de certains des tubes de guidage adjacents (3011) augmentent progressivement, le milieu de travail caloporteur est configuré pour s'écouler dans le deuxième canal de dissipation thermique (201) et le troisième canal de dissipation thermique (301), au moins une partie du milieu de travail caloporteur est configurée pour être liquéfiée dans une partie du deuxième canal de dissipation thermique (201), et le milieu de travail caloporteur liquéfié formé dans la deuxième zone de dissipation thermique (20) est directement distribué vers les tubes de guidage (3011) par le deuxième canal de dissipation thermique (201), puis guidé de manière directionnelle selon différentes directions en hauteur du premier canal de dissipation thermique (101) pour le réapprovisionnement en liquide.

2. Plaque conductrice de chaleur (1) selon la revendication 1, dans laquelle au moins une partie du milieu de travail caloporteur est configurée pour être vaporisée dans une partie du premier canal de dissipation thermique (101), et au moins une partie du milieu de travail caloporteur vaporisé s'écoule vers le deuxième canal de dissipation thermique (201) à travers le premier canal de dissipation thermique (101).

3. Plaque conductrice de chaleur (1) selon la revendication 1, dans laquelle la deuxième zone de dissipation thermique (20) comprend une pluralité de premières unités fermées (202), la troisième zone de dissipation thermique (30) comprend une pluralité de deuxièmes unités fermées (302), les premières unités fermées (202) sont entourées par au moins une partie du deuxième canal de dissipation thermique (201), les deuxièmes unités fermées (302) sont entourées par au moins une partie du troisième canal de dissipation thermique (301), et les premières unités fermées (202) et les deuxièmes unités fermées (302) sont configurées selon au moins l'une des modalités suivantes :
les premières unités fermées (202) sont des premières unités fermées (202) comprenant au moins une forme ou une taille ;
les deuxièmes unités fermées (302) sont des deuxièmes unités fermées (302) comprenant au moins une forme ou une taille ;
au moins certaines des premières unités fermées (202) ont une forme différente de celle des deuxièmes unités fermées (302) ; ou
au moins certaines des premières unités fermées (202) ont une taille différente de celle des deuxièmes unités fermées (302).

4. Plaque conductrice de chaleur (1) selon la revendication 1, dans laquelle les tubes de guidage (3011) sont en outre configurés selon au moins l'une des modalités suivantes :
une extrémité du tube de guidage (3011) proche de la deuxième zone de dissipation thermique (20) présente un diamètre supérieur à celui d'une extrémité du tube de guidage (3011) proche de la première zone de dissipation thermique (10) ; et
un angle entre l'extrémité proche de la première zone de dissipation thermique (10) et une première direction est inférieur à 45 degrés.

5. Plaque conductrice de chaleur (1) selon la revendication 1, dans laquelle la troisième zone de dissipation thermique (30) comprend un tube de communication (3012) qui relie au moins deux tubes de guidage adjacents (3011).

6. Plaque conductrice de chaleur (1) selon l'une quelconque des revendications 1 à 5, dans laquelle une zone de couplage (40) est disposée entre la deuxième zone de dissipation thermique (20) et la troisième zone de dissipation thermique (30), et le deuxième canal de dissipation thermique (201) et le troisième canal de dissipation thermique (301) communiquent par l'intermédiaire de la zone de couplage (40).

7. Appareil de dissipation thermique comprenant la plaque conductrice de chaleur (1) selon l'une quelconque des revendications 1 à 6.

8. Appareil de dissipation thermique selon la revendication 7, dans lequel l'appareil de dissipation thermique comprend une base configurée selon au moins l'une des modalités suivantes :
une cavité interne de la base communique avec la plaque conductrice de chaleur (1), la plaque conductrice de chaleur (1) est pourvue d'une buse ouverte, et la cavité interne de la base communique avec la plaque conductrice de chaleur (1) par l'intermédiaire de la buse ouverte ; ou
la cavité interne de la base ne communique pas avec la plaque conductrice de chaleur (1), et la plaque conductrice de chaleur (1) comporte une buse fermée.

9. Dispositif électronique comprenant la plaque conductrice de chaleur (1) selon l'une quelconque des revendications 1 à 6.

10. Dispositif électronique comprenant l'appareil de dissipation thermique selon la revendication 7 ou 8.
